(19) Europäisches Patentamt
European Patent Office
Office européen des brevets

(11) **EP 2 936 174 B1**

(12) **EUROPÄISCHE PATENTSCHRIFT**

(45) Veröffentlichungstag und Bekanntmachung des Hinweises auf die Patenterteilung:
**24.07.2019   Patentblatt 2019/30**

(51) Int Cl.:
*G01R 31/02* (2006.01)   *H02M 1/42* (2007.01)

(21) Anmeldenummer: **13802382.5**

(86) Internationale Anmeldenummer:
**PCT/EP2013/076041**

(22) Anmeldetag: **10.12.2013**

(87) Internationale Veröffentlichungsnummer:
**WO 2014/095479 (26.06.2014 Gazette 2014/26)**

(54) **ELEKTRISCHE BAUGRUPPE UND MESSVERFAHREN ZUR ÜBERWACHUNG VON BAUTEILEN DER ELEKTRISCHEN BAUGRUPPE**

ELECTRIC MODULE AND MEASUREMENT METHOD FOR PARTS OF THE MODULE

MODULE ELECTRONIQUE ET PROCEDE DE MESURE POUR DES COMPOSANTS DU MODULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.12.2012   DE 102012112901**

(43) Veröffentlichungstag der Anmeldung:
**28.10.2015   Patentblatt 2015/44**

(73) Patentinhaber: **Weidmüller Interface GmbH & Co. KG**
**32758 Detmold (DE)**

(72) Erfinder:
• **PAIZ GATICA, Carlos**
**32760 Detmold (DE)**

• **KUMAR, Martin**
**33609 Bielefeld (DE)**

(74) Vertreter: **Specht, Peter**
**Loesenbeck - Specht - Dantz**
**Patent- und Rechtsanwälte**
**Am Zwinger 2**
**33602 Bielefeld (DE)**

(56) Entgegenhaltungen:
DE-A1- 10 061 439          US-A1- 2004 046 230
US-A1- 2006 038 692        US-A1- 2010 079 150
US-A1- 2012 056 667

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die vorliegende Erfindung betrifft ein elektrische Baugruppe, insbesondere ein Netzteil, mit einer Messschaltung, mit der ein Alterungszustand eines Bauteils der elektrischen Baugruppe im Betrieb der elektrischen Baugruppe bestimmbar ist.

In Netzteilen werden Kondensatoren sowohl primärseitig als auch sekundärseitig zur Glättung und Stabilisation von Spannungen, insbesondere von gleichgerichteten Wechselspannungen, eingesetzt. Häufig werden dafür Elektrolytkondensatoren verwendet, weil diese ein hohes Energiespeichervermögen aufweisen und verhältnismäßig preiswert sind. Es ist jedoch bekannt, dass die Speicherkapazität von Kondensatoren, insbesondere von Elektrolytkondensatoren, mit zunehmender Zahl ihrer Betriebsstunden abnimmt, beispielsweise aufgrund von Wärmebelastung oder hohen Rippelströmen (Spitzen- Spitzen- Werte der Restwelligkeit). Auch verschlechtert sich der Verlustfaktor von Kondensatoren mit zunehmender Zahl ihrer Betriebsstunden.

In Netzteilen hat sich gezeigt, dass Kondensatoren häufig die Lebensdauer der Netzteile entscheidend begrenzen.

Die Druckschrift DE 10 2005 058 719 A1 schlägt zur Diagnose eines Autarkiekondensators, der zum Auslösen eines Airbags in einem Kraftfahrzeug genutzt wird, vor, die Nominalspannung am Kondensator kurzzeitig zu überhöhen. Dadurch wird ein zu einer verringerten Autarkiezeit führender zu hoher Spannungshub während der Messung vermieden. Die vorgeschlagene Messung ist deshalb auch während eines Fahrzeugbetriebs möglich. Jedoch verändert eine Überhöhung der Nominalspannung prinzipiell auch das Spannungs- und Stromverhalten der Schaltung.

Siehe auch US 2006/038692.

Aufgabe der vorliegenden Erfindung ist es, eine elektrische Baugruppe und ein Verfahren bereitzustellen, die eine Messung einer Eigenschaft eines Bauteils während des Betriebes der elektrischen Baugruppe, insbesondere eines Netzteils, lastunabhängig und kostengünstig ermöglicht, wobei die Funktion, das Verhalten und die Leistungsaufnahme der elektrischen Baugruppe während ihres Betriebes durch die Messung möglichst nicht beeinträchtigt werden.

Die Erfindung löst diese Aufgabe mit einer elektrischen Baugruppe gemäß dem Patentanspruch 1 und dem Verfahren gemäß dem Patentanspruch 11.

Die Aufgabe wird gelöst, indem eine elektrische Baugruppe Mittel zum Anschließen einer Messschaltung oder die Messschaltung, eine Arbeitsschaltung, ein erstes Bauteil sowie zumindest ein zweites Bauteil desselben Typs, insbesondere ein baugleiches zweites Bauteil, umfasst, wobei die beiden Bauteile unabhängig voneinander in die Arbeitsschaltung oder in die Messschaltung einkoppelbar oder auskoppelbar sind.

Der Lösung der Aufgabe liegt die Idee zu Grunde, das erste Bauteil während des Betriebs der elektrischen Baugruppe aus seiner Funktion zu nehmen und eine von der elektrischen Baugruppe unabhängige, definierte Messumgebung zu schaffen. Anstelle des ersten Bauteils arbeitet die elektrische Baugruppe während der Messung seiner Eigenschaft mit dem zweiten Bauteil desselben Typs weiter.

Es ist bevorzugt, dass die elektrische Baugruppe nicht nur Anschlüsse zum Anschließen der Messschaltung, sondern die Messschaltung selbst umfasst. Dadurch werden die Funktion und das Verhalten der elektrischen Baugruppe während des Betriebes sowie seine Leistungsaufnahme nicht durch ein Einkoppeln der Messschaltung beeinflusst. Prinzipiell ist es aber auch denkbar, zumindest einen Teil der Messschaltung oder die gesamte Messschaltung über eine Schnittstelle während des Betriebes der elektrischen Baugruppe in diese einkoppelbar vorzusehen.

Eine elektrische Baugruppe im Sinne der Erfindung ist ein Netzteil. Ein Netzteil ist zur Bereitstellung einer definierten Spannung vorgesehen, insbesondere einer Gleichspannung.

Ein Bauteil im Sinne der Erfindung ist jedes in einer elektrischen Baugruppe zur Wandlung von Spannungen, Strömen, Leistungen und/oder Frequenzen genutzte einzelne, insbesondere analoge, Bauteil. Auch die Zusammenschaltung mehrerer solcher einzelner, gleicher oder verschiedener Bauteile, beispielsweise ein RC- oder ein RL- Glied, ist ein Bauteil im Sinne der Erfindung. Denn die zugrunde liegende Idee ermöglicht zumindest im begrenzten Rahmen auch die Analyse komplexer Schaltungen, nämlich das Black- Box- Verhalten einer solchen Schaltung, also eine Analyse auf Grundlage ihrer Ein- und Ausgangs- Spannungen, -Ströme, -Frequenzen und -Leistungen.

Das Bauteil ist ein Kondensator, insbesondere ein Elektrolytkondensator.

In einer ebenfalls bevorzugten Ausführungsform umfasst die elektrische Baugruppe zum Einkoppeln oder Auskoppeln der beiden Bauteile in die Arbeitsschaltung oder in die Messschaltung zwei Schalter, die den beiden Bauteilen jeweils zugeordnet sind. Aus einer Schaltung ausgekoppelt ist ein Bauteil, wenn ein Schalter, der das Bauteil mit der Schaltung verbindet, geöffnet ist. Eingekoppelt ist das Bauteil in die Schaltung, wenn der Schalter geschlossen ist.

Das erste Bauteil und das zweites Bauteil sind bevorzugt baugleich ausgeführt, so dass sie gleichwertige Bauteile der elektrischen Baugruppe sind. Es ist aber ebenfalls eine Ausführungsform bevorzugt, in der ein nicht baugleiches zweites Bauteil vorgesehen ist, mit dem der Betrieb der Arbeitsschaltung während der Messung des ersten Bauteils aufrecht erhaltbar ist. Diese Ausführungsform ist besonders bei sehr teuren, beispielsweise bei Präzisionsbauteilen, bevorzugt. Dann ist ein im Vergleich zum ersten Bauteil kostengünstigeres zweites Bauteil bevorzugt, das in der elektrischen Baugruppe die Funktion eines Ersatzbauteils für das erste Bauteil einnimmt.

Als Schalter zum Ein- und Auskoppeln des ersten Bauteils und des zweites Bauteils sind bevorzugt jeweils elektronische Schalter, insbesondere ein MOSFET (Metal Oxide Semiconductor Field Effect Transistor), vorgesehen. Es sind aber auch ein anderer Transistor, ein Relais, ein mechanischer Schalter oder ähnlich bevorzugt. Ein elektronischer Schalter hat gegenüber einem mechanischen Schalter den Vorteil, dass er elektronisch steuerbar ist. Ein MOSFET hat gegenüber anderen Transistoren den Vorteil, dass er in Bezug auf die Stromrichtung nicht beschränkt ist.

Es ist bevorzugt, dass zumindest entweder das erste Bauteil oder das zweite Bauteil im Betrieb der elektrischen Baugruppe in die Arbeitsschaltung eingekoppelt ist, damit die Funktion und das Verhalten der elektrischen Baugruppe während des Betriebes gewährleistet ist.

Um die Funktion und das Verhalten der elektrischen Baugruppe während des Betriebes nicht durch eine Messung zu beeinflussen, ist es zudem bevorzugt, dass das erste Bauteil in einem Messbetrieb der Messschaltung aus der Arbeitsschaltung ausgekoppelt ist. Dadurch wird das erste Bauteil von der Arbeitsschaltung isoliert. Das erste Bauteil wird daher elektrisch unabhängig von der Arbeitsschaltung, und somit auch unabhängig von der angeschlossenen Last. Daher lässt sich unabhängig von der ursprünglichen Aufgabe des Bauteils innerhalb der elektrischen Baugruppe ein Analyseverfahren anwenden, das die Parameter der definierten Messumgebung nutzt. Im Vergleich zu einer herkömmlichen elektrischen Baugruppe umfasst die erfindungsgemäße Baugruppe zusätzlich zumindest das während der Messung des ersten Bauteils in die Arbeitsschaltung eingekoppelte zweite Bauteil und die Schalter zum Ein- und Ausschalten des ersten Bauteils und des zweiten Bauteils. Optional umfasst sie zudem die Messschaltung.

Zum Ausführen der Messung ist es bevorzugt, dass die Messschaltung zumindest einen Messwiderstand zum Entladen des ersten Bauteils während des Messbetriebes umfasst. Dem Messwiderstand ist vorzugsweise ein Messschalter zugeordnet, mit dem er in die Messschaltung einkoppelbar und auskoppelbar ist. Dadurch ist der Messwiderstand nur während der Messung in die Messschaltung so einkoppelbar, dass er den Betrieb der elektrischen Baugruppe nicht beeinflusst.

Weiterhin bevorzugt weist die elektrische Baugruppe einen Ladewiderstand auf, über den das erste Bauteil aufladbar ist, bevor es in die Arbeitsschaltung eingekoppelt wird. Es ist bevorzugt, dass dem Ladewiderstand ein Ladeschalter zugeordnet ist, so dass der Ladewiderstand aus der Schaltung ein- und auskoppelbar ist. Durch das Vorladen des ersten Bauteils vor dem Einkoppeln in die Arbeitsschaltung werden große Strom- und Spannungsänderungen aufgrund von Ladungsverschiebungen vermieden. Zum Ein- und Auskoppeln des Ladewiderstandes ist bevorzugt ein Transistor als Ladeschalter vorgesehen. Prinzipiell sind aber auch hier andere elektronische oder mechanische Schalter verwendbar.

Da zur Erfassung der Eigenschaft des ersten Bauteils das zweite Bauteil während des Betriebes der elektrischen Baugruppe in diese eingekoppelt ist, ist es zudem bevorzugt, dass dem zweiten Bauteil ebenfalls ein Ladewiderstand sowie ein Ladeschalter zugeordnet sind, so dass es vor dem Einkoppeln in die Arbeitsschaltung vorladbar ist.

In einer besonders bevorzugten Ausführungsform ist auch die Eigenschaft des zweiten Bauteils erfassbar. Dafür umfasst die elektrische Baugruppe auch für das zweite Bauteil den Messwiderstand mit dem ihm zugeordneten Messschalter.

Dadurch ist das zweite Bauteil ebenso prüfbar, wie das erste Bauteil. Das zweite Bauteil ist in dieser Ausführungsform in Bezug auf den Betrieb und die Lebensdauer der elektrischen Baugruppe nicht redundant. Sondern es ist vollwertig in die Arbeitsschaltung einkoppelbar und als Ersatz für das erste Bauteil verwendbar, wenn das erste Bauteil seine Funktion nicht mehr erfüllt. Es ist daher besonders bevorzugt, dass das zweite Bauteil dem ersten Bauteil gleichwertig vorgesehen ist. Gleichwertig in diesem Sinne ist das zweite Bauteil, wenn es die für die Messung der Eigenschaft erforderlichen Bauteile umfasst, insbesondere hier den Messwiderstand und den Ladewiderstand, gegebenenfalls mit den ihnen jeweils zugeordneten Schaltern.

Zur Erfassung der Eigenschaft des ersten Bauteils und/oder des zweiten Bauteils ist es bevorzugt, dass die Messschaltung einen Prozessor umfasst, mit dem im Messbetrieb ein Messwert, insbesondere der durch das erste Bauteil fließende Strom und/oder die am ersten Bauteil anliegende Spannung beim Entladen, insbesondere über den Messwiderstand, erfassbar ist. Vorzugsweise werden dabei eine Vielzahl Messwerte, insbesondere in gleichen Zeitabständen, erfasst. Als Messwerte sind auch eine Leistungsaufnahme, eine Frequenz, eine Temperatur oder ähnlich erfassbar. Der Prozessor erfasst die Eigenschaft bevorzugt durch einen Vergleich von aus den Messwerten berechneten Ergebniswerten mit Referenzwerten.

Als Prozessor wird bevorzugt ein Mikroprozessor eingesetzt, oder ganz besonders bevorzugt ein Mikrocontroller, der neben dem Mikroprozessor weitere benötigte Peripheriefunktionen bereitstellt, wie beispielsweise einen Speicherbereich, insbesondere zum Speichern der erfassten Messwerte. Es ist bevorzugt, dass der Prozessor den Messwert oder die Messwerte, beispielsweise den im Messbetrieb durch das erste Bauteil fließenden Strom und/oder die am Bauteil anliegende Spannung, digital erfasst. Dafür umfasst die Messschaltung bevorzugt einen Analog- Digital- Wandler. Der Analog- Digital- Wandler ermöglicht ein Wandeln eines analogen in ein digitales Signal.

Die Messschaltung umfasst weiterhin bevorzugt einen Speicherbereich zum Speichern von Initialwerten, Referenzwerten und/oder der Messwerte. Zudem ist es bevorzugt, dass sie zumindest ein Ausgabemittel, beispielsweise ein Display, zur Ausgabe der Eigenschaft des ersten und/oder zweiten Bauteils umfasst. Alternativ oder zusätzlich ist es möglich, dass die Messschaltung eine Schnittstelle zum Anschluss eines Ausgabemittels umfasst. Dabei ist das Ausgabemittel beispielsweise das Display oder ein Drucker oder ähnlich. Weiterhin ist es alternativ oder zusätzlich möglich, die erfasste Eigenschaft und/oder Messwerte über eine Kommunikationsschnittstelle wie beispielsweise eine Feldbusschnittstelle auszugeben.

Die Aufgabe wird weiterhin gelöst mit einem Verfahren zum Messen von Messwerten, mit denen eine Eigenschaft eines ersten Bauteils einer erfindungsgemäßen elektrischen Baugruppe während ihres Betriebes erfassbar ist, mit den Schritten:

- Einkoppeln eines zweiten Bauteils in eine Arbeitsschaltung der elektrischen Baugruppe,
- Auskoppeln des ersten Bauteils aus der Arbeitsschaltung,
- Erfassung der Messwerte, und
- Berechnung der Eigenschaft des ersten Bauteils.

Dabei sind die Bauteile Kondensatoren, während die Baugruppe ein Netzteil ist.

Das Verfahren ermöglicht das Messen der Eigenschaft des ersten Bauteils während des Betriebes der elektrischen Baugruppe, indem das erste Bauteil aus der Arbeitsschaltung ausgekoppelt wird. Dafür wird vor dem Auskoppeln ein zweites Bauteil in die Arbeitsschaltung eingekoppelt. Die Arbeitsschaltung, das erste Bauteil sowie das zweite Bauteil sind bevorzugt so ausgelegt, dass durch das Ein- und Auskoppeln des ersten Bauteils und des zweiten Bauteils gegebenenfalls kurzzeitig entstehende Spannungs- und/oder Stromspitzen den Betrieb der elektrischen Baugruppe nicht beeinträchtigen.

Als Messwerte werden bevorzugt der durch das erste Bauteil fließende Strom und/oder die am ersten Bauteil anliegende Spannung beim Entladen des ersten Bauteils, insbesondere über den Messwiderstand, erfasst. Es sind aber auch andere Messwerte erfassbar, beispielsweise eine vom ersten Bauteil aufgenommene Leistung oder eine Frequenz.

Die Bauteile sind bevorzugt Kondensatoren, wobei die erfasste Eigenschaft bevorzugt die Kapazität des ersten Kondensators ist. Die Erfindung ist aber nicht auf die Bestimmung der Kapazität beschränkt, sondern allgemein für Eigenschaften eines Bauteils nutzbar, die mittels elektrisch erfassbarer Messwerte bestimmbar sind.

Zur Bestimmung der Kapazität des Kondensators ist es bevorzugt, dass als Messwerte die Entladespannung des Kondensators nach dem Auskoppeln aus der Arbeitsschaltung erfasst wird. Ebenfalls bevorzugt wird die Kapazität des Kondensators über den Entladestrom, eine Leistungsaufnahme, einen Frequenzverlauf oder weitere die Kapazität charakterisierende Kondensatoreigenschaften erfasst.

Es ist bevorzugt, dass die Eigenschaft des ersten Bauteils an einem Ausgabemittel, insbesondere an einem Leuchtmittel, beispielsweise einer LED, an eine Kommunikationsschnittstelle, beispielsweise eine Feldbusschnittstelle, oder einem Display, ausgegeben wird. Weiterhin bevorzugt wird sie gespeichert, insbesondere um diesen Wert als Referenzwert für eine spätere Messung verwenden zu können.

Besonders bevorzugt wird durch Vergleich der Eigenschaft des ersten Bauteils mit einem Referenzwert oder mehreren Referenzwerten auf seinen Alterungszustand und/oder einen Defekt des Bauteils geschlossen.

Um das erste Bauteil oder das zweite Bauteil in die Arbeitsschaltung einzukoppeln, ist es bevorzugt, dass es vor dem Einkoppeln zumindest teilweise aufgeladen wird. Dadurch werden mögliche Spannungs- und Stromänderungen aufgrund von Ladungsverschiebungen vermieden, die zur Beeinträchtigung des Betriebes der elektrischen Baugruppe und/oder zu einer Beeinträchtigung der Messung führen könnten.

Die Aufgabe wird weiterhin gelöst mit einem Verfahren zum Betreiben einer erfindungsgemäßen elektrischen Baugruppe, wobei entweder das erste Bauteil oder das zweite Bauteil in die Arbeitsschaltung eingekoppelt und das andere Bauteil aus der Arbeitsschaltung ausgekoppelt ist, während eine Eigenschaft des anderen Bauteils mit der Messschaltung gemessen wird. Da das andere Bauteil während der Messung aus der Arbeitsschaltung ausgekoppelt ist, beeinträchtigt es den Betrieb der Arbeitsschaltung nicht. Zudem ermöglicht das Auskoppeln des anderen Bauteils aus der Arbeitsschaltung die Schaffung einer definierten Messumgebung, die eine sehr genaue Bestimmung der Eigenschaft des anderen Bauteils während des Betriebes der Arbeitsschaltung beziehungsweise der elektrischen Baugruppe ermöglicht.

Bevorzugt erfolgt die Messung der Eigenschaft für beide Bauteile abwechselnd, insbesondere zyklisch. Besonders bevorzugt erfolgt die Messung für beide Bauteile, in definierten Zeitabständen, insbesondere automatisch. Mit der Messung wird bevorzugt eine Eigenschaft des Bauteils erfasst, aus der auf den Alterungszustand und/oder einen Defekt des Bauteils geschlossen werden kann. In dieser Konstellation ermöglicht das automatische Messen der Eigenschaft beider Bauteile, einen Nutzer der elektrischen Baugruppe rechtzeitig vor einem alten oder defekten Bauteil zu warnen.

Zudem ist es bevorzugt, dass ein defektes und/oder altes erstes oder zweites Bauteil nicht mehr in die Arbeitsschaltung eingekoppelt wird.

Nachfolgend wird die Erfindung unter Bezug auf die Zeichnungen anhand von Ausführungsbeispielen näher erläutert, wobei weitere Vorteile der Erfindung deutlich werden. Es zeigt:

Fig. 1     schematisch eine herkömmliche elektrische Baugruppe am Beispiel eines Netzteils,

Fig. 2 schematisch einen Ausschnitt aus einer erfindungsgemäßen elektrischen Baugruppe,

Fig. 3 schematisch eine erfindungsgemäße elektrischen Baugruppe am Beispiel eines Netzteils,

Fig. 4 schematisch einen Ausschnitt aus dem Netzteil der Fig. 3 mit einem ersten Bauteil,

Fig. 5 in (a) als Ergebnis einer Messung eine Entladekurve des ersten Bauteils der Fig. 4, und in (b) eine Regression der Messung, und

Fig. 6 schematisch einen weiteren Ausschnitt aus dem Netzteil der Fig. 3 mit dem ersten Bauteil und dem zweites Bauteil.

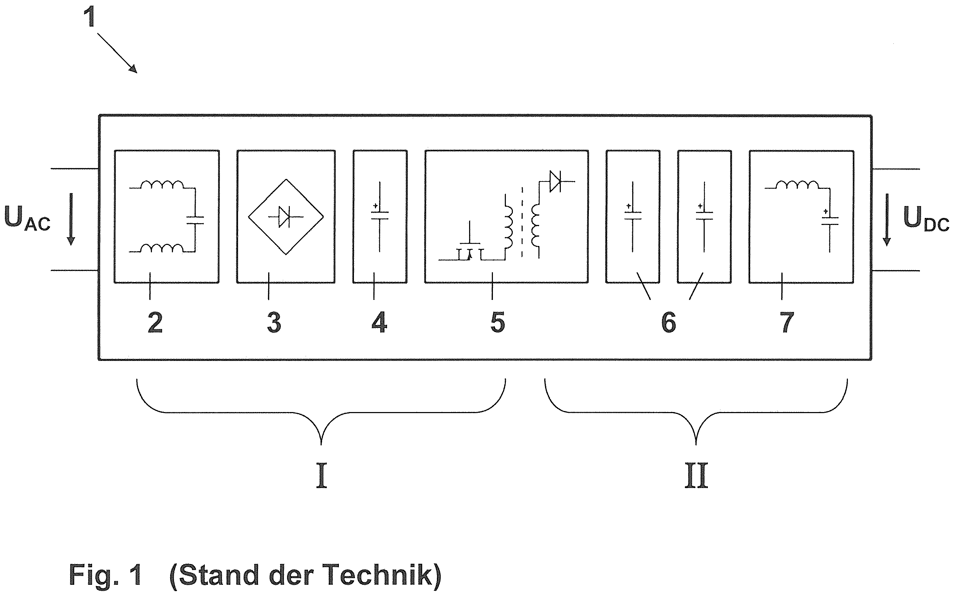

Die in der Fig. 1 dargestellte, herkömmliche elektrische Baugruppe 1 ist ein Netzteil, das zum Umwandeln einer Eingangswechselspannung $U_{AC}$ in eine definierte Ausgangsgleichspannung $U_{DC}$ vorgesehen ist. Das Netzteil 1 weist eine Primärseite I und eine Sekundärseite II auf. Im Folgenden werden die Begriffe elektrische Baugruppe 1 und Netzteil synonym verwendet.

Primärseitig wird ein Leistungsfaktor des Netzteils 1 zunächst mittels eines passiven Leistungsfaktorkorrekturfilters 2 (PFC, Power Factor Correction) erhöht. In Abhängigkeit von der Leistung des Netzteils 1 ist aber auch ein aktiver Leistungsfaktorkorrekturfilter (nicht gezeigt) verwendbar. Anschließend wird die Eingangswechselspannung $U_{AC}$ über einen Gleichrichter 3 gleichgerichtet. Ein primärer Elektrolytkondensator 4 ist zum Glätten der gleichgerichteten Eingangswechselspannung $U_{AC}$ vorgesehen. Ein Sperrwandler 5 bewirkt eine galvanische Trennung zwischen der Primärseite I und der Sekundärseite II. Sekundärseitig ist die Eingangswechselspannung $U_{AC}$ in eine pulsierende Gleichspannung gewandelt. Um diese pulsierende Gleichspannung zu stabilisieren und zu glätten, sind sekundärseitig zwei sekundäre Elektrolytkondensatoren 6 angeordnet. Ein den Elektrolytkondensatoren 6 direkt nach geschalteter LC- Tiefpass 7 filtert eine Schaltfrequenz aus der Ausgangsgleichspannung $U_{DC}$, um die Restwelligkeit zu verringern.

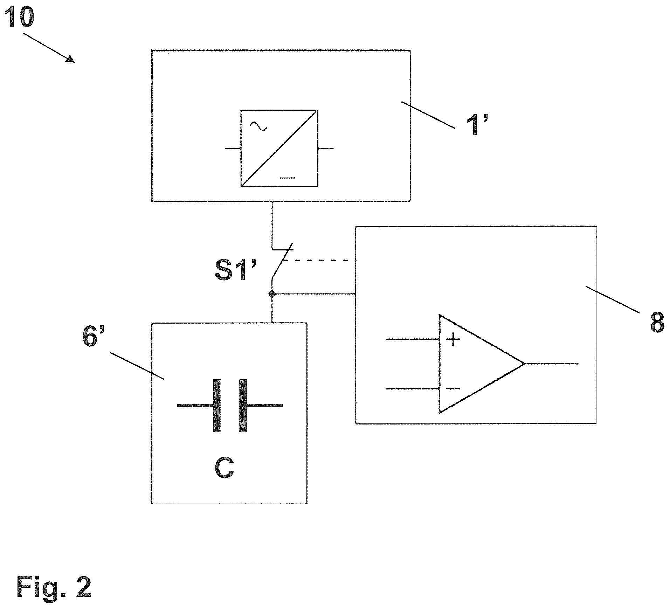

In Fig. 2 ist die zugrunde liegende Idee der Erfindung schematisch dargestellt. Eine erfindungsgemäße elektrische Baugruppe 10 weist eine Arbeitsschaltung 1' sowie eine Messschaltung 8 auf. Ein erstes Bauteil 6' der elektrischen Baugruppe 10, hier ein Kondensator der elektrischen Baugruppe 10, ist über einen Schalter S1' aus der Arbeitsschaltung 1' auskoppelbar. Bei geschlossenem Schalter S1' ist das erste Bauteil 6' in die Arbeitsschaltung 1' eingekoppelt, so dass es sich im Betrieb der elektrischen Baugruppe seiner Funktion innerhalb der Arbeitsschaltung entsprechend verhält. Bei offenem Schalter S1' ist es aus der Arbeitsschaltung 1' ausgekoppelt. Das ausgekoppelte erste Bauteil 6' bildet zusammen mit der Messschaltung 8 eine definierte Messumgebung, in der Eigenschaften des ersten Bauteils 6' mit Hilfe elektrisch durchführbarer Messungen erfassbar sind.

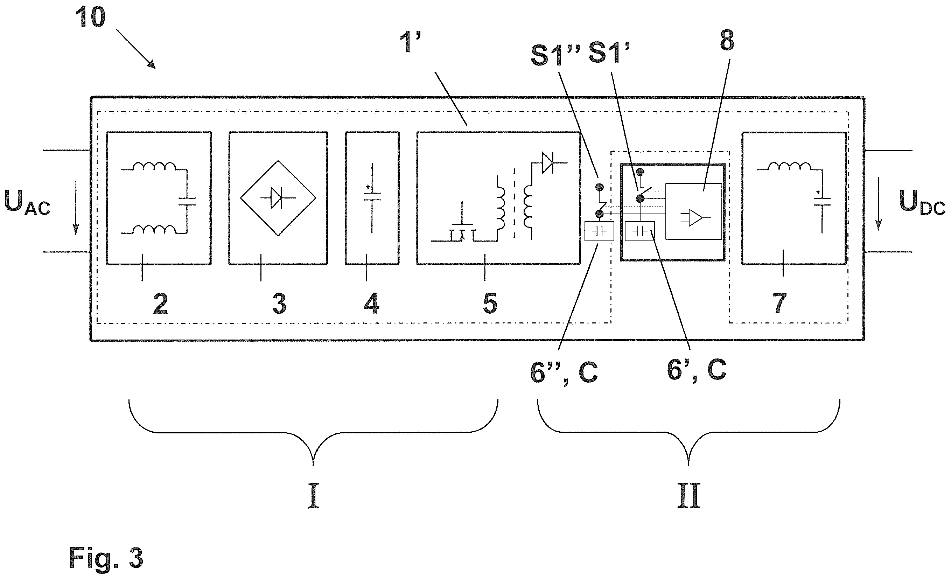

Die Fig. 3 erläutert die Erfindung am Beispiel eines erfindungsgemäßen Netzteils 1. Beim vorliegenden Ausführungsbeispiel ist die Messung eines Elektrolytkondensators 6' auf der Sekundärseite II vorgesehen, und zwar hier speziell eines Aluminium- Elektrolytkondensators. Die vorliegende Erfindung ist aber auch auf die Messung des primärseitig angeordneten Elektrolytkondensators 4 anwendbar. Zudem ist sie auch nicht auf Elektrolytkondensatoren 4, 6' beschränkt, sondern allgemein auf elektrische Bauteile (nicht gezeigt), insbesondere auf Speicherbauteile wie Kondensatoren oder Spulen, und auf Schaltungen aus mehreren solchen Bauteilen anwendbar.

Primärseitig I entspricht das Netzteil 10 dem in Fig. 1 dargestellten herkömmlichen Netzteil 1. Sekundärseitig II sind jedoch anstelle der beiden sekundären Elektrolytkondensatoren 6 (s. Fig. 1) die Messschaltung 8, das erste Bauteil 6', das hier als Elektrolytkondensator ausgebildet ist, ein zweites Bauteil 6", das hier ebenfalls als Elektrolytkondensator ausgebildet und dem ersten Bauteil 6' baugleich ist, sowie zwei Schalter S1', S1" vorgesehen. Dabei ist einer der beiden Schalter S1' dem ersten Bauteil 6' und der andere Schalter S1" dem zweiten Bauteil 6" zugeordnet, so dass das erste Bauteil 6', C und das zweite Bauteil 6" jeweils mit dem ihm zugeordneten Schalter S1', S1" in die Arbeitsschaltung 1' einkoppelbar oder aus dieser auskoppelbar ist. In der Darstellung der Fig. 3 ist der dem zweiten Bauteil 6" zugeordnete Schalter S1" geschlossen, und der dem ersten Bauteil 6' zugeordnete Schalter S1' geöffnet. Konkret zeigt diese Darstellung daher das in die Arbeitsschaltung 1' eingekoppelte zweite Bauteil 6", während das erste Bauteil 6' aus der Arbeitsschaltung 1' ausgekoppelt ist. Das zweite Bauteil 6" vervollständigt die Arbeitsschaltung 1' der elektrischen Baugruppe 10 während einer Messung der Eigenschaft des ersten Bauteils 6', so dass ein Betrieb der elektrischen Baugruppe 10 auch während der Messung möglich ist.

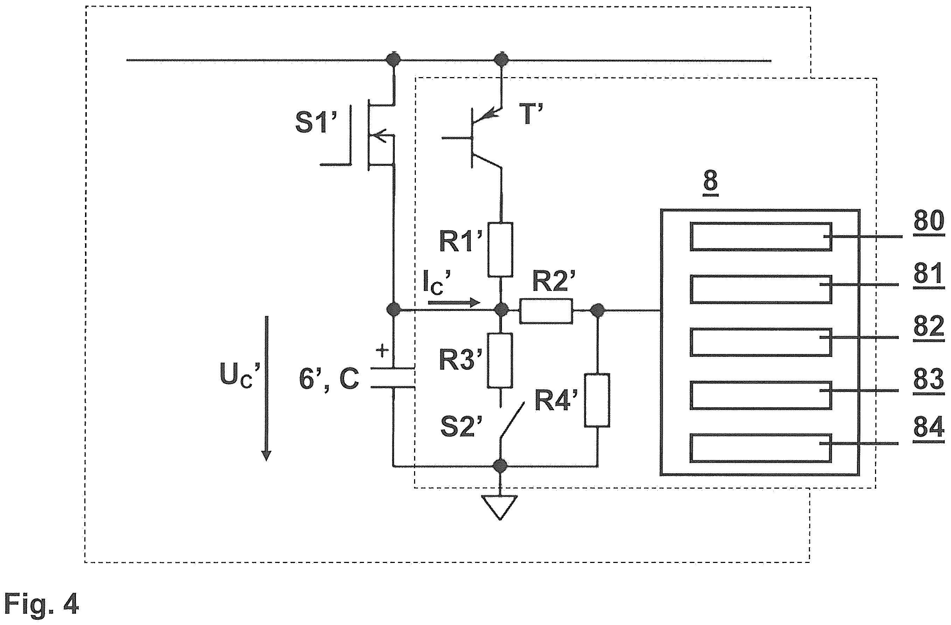

Die Fig. 4 zeigt die Messschaltung 8 und das erste Bauteil 6' mit dem ihm zugeordneten Schalter S1'. Das erste Bauteil 6' ist hier ein Kondensator. Im Folgenden werden daher die Begriffe erstes Bauteil 6' und Kondensator synonym verwendet. Der Schalter S1' ist als elektrischer Schalter, und zwar hier als MOSFET, ausgebildet. Dadurch ist er elektrisch steuerbar. Um den Schalter S1' elektrisch zu steuern, umfasst die Messschaltung 8 einen Mikroprozessor 81 der einen Steuerstrom für den Schalter S1' so steuert, dass dieser geöffnet oder geschlossen ist.

Wenn der Schalter S1' geschlossen ist, arbeitet das erste Bauteil 6' in seiner Funktion innerhalb der Arbeitsschaltung 1', nämlich der Stabilisierung und Glättung der sekundärseitigen am Ausgang des Sperrwandlers 5 anliegenden pulsierenden Gleichspannung. Bei geöffnetem Schalter S1' ist das erste Bauteil 6' aus der Arbeitsschaltung 1' ausgekoppelt.

Die Messschaltung 8 umfasst ein Eingabemittel 84, mit dem eine Messung eingeleitet werden kann. Zudem umfasst sie einen Spannungsteiler R2', R4', der eine definierte Spannung für einen Analog- Digital- Wandler 80 zur Verfügung stellt. Der Analog- Digital- Wandler 80 wandelt ein Messsignal $U_C$, $I_C$, beispielsweise die Entladespannung $U_C$ und/oder den Entladestrom $I_C$ des ersten Bauteils 6', in ein digitales Signal für den Mikroprozessor 81 um. Der Mikroprozessor 81 berechnet aus den digitalen Messwerten $U_C$, $I_C$ die Eigenschaft, beispielsweise hier den Alterungszustand des ersten Bauteils 6' anhand seiner Kapazität. Um die Messwerte $U_C$, $I_C$ zu speichern, ist ein Datenspeicher 82 vorgesehen, der zudem zum Speichern von Initial- und/oder Referenzwerten vorgesehen ist. Außerdem umfasst die Messschaltung 8 ein Ausgabemittel 83, beispielsweise ein Display, eine Kommunikationsschnittstelle oder einen Drucker, zur Ausgabe der Messwerte $U_C$, $I_C$ und/oder der Eigenschaft.

Um eine Messung durchzuführen, ist hier ein Entladewiderstand R3' vorgesehen, der dem ersten Bauteil 6' über einen Messschalter S2', der als Relais, Transistor oder ähnlich ausgebildet ist, vor dem Durchführen der Messung parallel geschaltet wird. Der Messschalter S2' ist bevorzugt nur während der Durchführung der Messung geschlossen. Er ist daher bevorzugt geöffnet, wenn das erste Bauteil 6' im Betrieb der elektrischen Baugruppe 10 innerhalb der Arbeitsschaltung 1' genutzt wird.

Im Messbetrieb erfolgt das Entladen des ersten Bauteils 6' über das aus dem Entladewiderstand R3' und dem Spannungsteiler R2', R4' gebildete Widerstandsnetzwerk R.

Im Betrieb der elektrischen Baugruppe 10 ist derjenige Kondensator 6', 6" der in der Arbeitsschaltung 1' genutzt wird, auf ein Teilniveau geladen. Um ein langsames Einkoppeln des ersten Bauteils 6' zu ermöglichen, ist zudem ein Ladewiderstand R1' vorgesehen, dem ein Ladeschalter T', hier ein Feldeffekttransistor, zugeordnet ist, und mit dem der Ladewiderstand R1' in die Messschaltung einkoppelbar und auskoppelbar ist. Der Ladeschalter T' ist bevorzugt nur während des Vorladens des ersten Bauteils 6' über den Ladewiderstand R1' geschlossen. Auch er ist daher bevorzugt geöffnet, wenn das erste Bauteil 6' im Betrieb der elektrischen Baugruppe 10 innerhalb der Arbeitsschaltung 1' genutzt wird.

Um die Eigenschaft, hier vor allem den Alterungszustand des ersten Bauteils 6' zu bestimmen, wird das Gleichspannungsverhalten des ersten Bauteils 6' genutzt. Im vorliegenden Ausführungsbeispiel wird die Entladespannung $U_C$ des ersten Kondensators 6' gemessen, und die Messwerte vom Mikroprozessor 81 aufgezeichnet. Mit Hilfe des Mikroprozessors 81 wird anhand der Entladespannung Uc die Kapazität des ersten Kondensators 6' bestimmt. Die Bestimmung der Kapazität wird mit Hilfe der Gleichung

$$U_C(t) = U_C(0) * exp(-t/RC)$$

ermittelt. Dabei sind

$U_C(t)$ = die Entladespannung [in V] gemessen über der Zeit t
$U_C(0)$ = Spannung des geladenen Kondensators [in V], Anfangswert
t = die Zeit [in s]
R = der Gesamtwiderstand des Widerstandsnetzwerkes aus R2' - R4'
C = die Kapazität des Kondensators

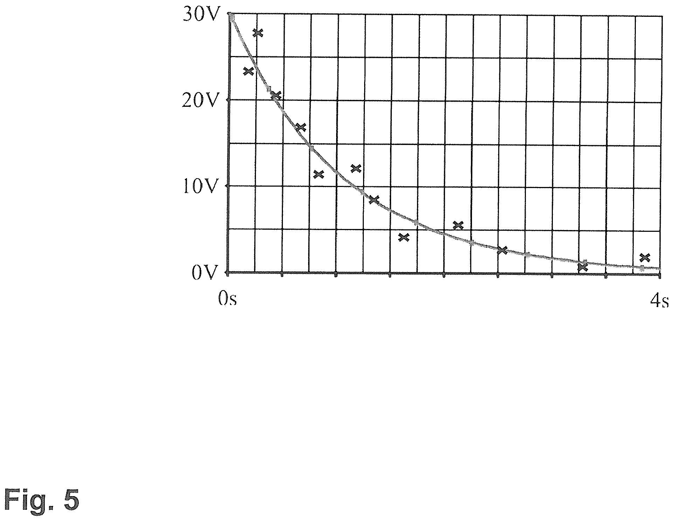

Einen solchen über die Zeit gemessenen Entladespannungsverlauf $U_C(t)$ zeigt die Fig. 5(a).

Zur Bestimmung der Kapazität C wird hier bevorzugt eine lineare Regression genutzt, bei der der Entladespannungsverlauf $U_C(t)$ über den natürlichen Logarithmus ln in eine lineare Funktion transformiert wird. C

Der erste Kondensator 6' wird als defekt eingestuft, wenn er seine Anfangskapazität um einen Vorgabewert, insbesondere um 20%, unterschreitet.

Die Anfangskapazität liegt bevorzugt als Initialwert im Datenspeicher 82 vor. Um die Genauigkeit der Messung zu gewährleisten, werden bevorzugt mehrere Messungen mit einer definierten Anzahl von Messwerten durchgeführt. Es hat sich gezeigt, dass das Verfahren eine ausreichend genaue Einschätzung des Alterungszustandes des ersten Kondensators 6' ermöglicht.

Um das zweite Bauteil 6" bei einem defekten ersten Bauteil 6' als vollwertigen Ersatz in der elektrischen Baugruppe 10 nutzen zu können, ist es bevorzugt, auch das zweite Bauteil 6" mit der für die Messung benötigten Beschaltung zu versehen.

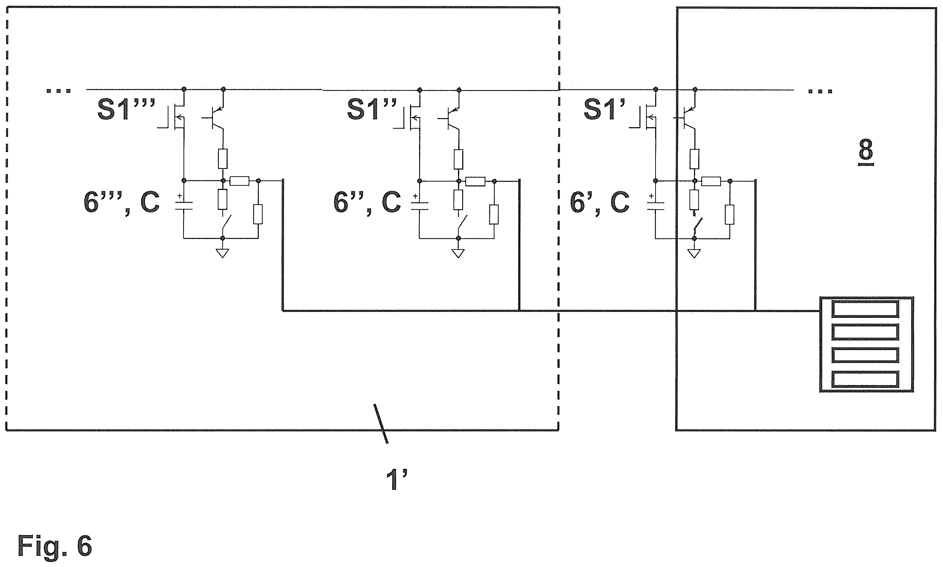

Die Fig. 6 zeigt schematisch einen Ausschnitt aus einer erfindungsgemäßen elektrischen Baugruppe 10, die neben dem ersten Bauteil 6' und dem zweiten Bauteil 6" ein drittes Bauteil 6''' desselben Typs umfasst. Dabei werden in der Arbeitsschaltung 1' immer zwei der Bauteile 6', 6", 6''' genutzt. Die Arbeitsschaltung 1' der elektrischen Baugruppe 10 der Fig. 6 weist im Übrigen die Komponenten 2, 3, 4, 5, 7 der Arbeitsschaltung 1' der elektrischen Baugruppe 10 der Fig. 3 auf.

Alle drei Bauteile 6', 6", 6'''sind mit der Beschaltung entsprechend der Fig. 4, das heißt mit dem Ladewiderstand R1', R1", R1 "', dem Entladewiderstand R3', R3", R3''', dem Spannungsteiler R2', R4', R2", R4", R2''', R4''' sowie den jeweils zum Ein- und Auskoppeln benötigten Schaltern S2', S2", S2''', T', T", T''', für die Messung versehen und mit der Messschaltung 8 verbunden. Die Bezugszeichen sind in der Fig. 6 aber zugunsten der Übersichtlichkeit nicht eingezeichnet. Die freien Bauteile 6', 6", 6'''sind daher als gleichwertig anzusehen. Dadurch ist es möglich, eines der drei Bauteile 6' aus der Arbeitsschaltung 1' anzukoppeln, während der Betrieb der elektrischen Baugruppe 10 mit den übrigen beiden Bauteilen 6", 6''' fortgeführt wird.

Ist eines der Bauteile 6' als defekt anzusehen, ist der Betrieb der elektrischen Baugruppe weiterhin mit den anderen beiden Bauteilen 6", 6''' möglich. Das zweite Bauteil 6" ermöglicht daher nicht nur eine Messung des Alterungszustandes der Bauteile 6', 6", 6''' während des Betriebes der elektrischen Baugruppe. Es ist auch als Ersatz vollwertig nutzbar und verlängert daher die durchschnittliche Lebensdauer der in Fig. 6 dargestellten elektrischen Baugruppe 10 um mehr als 30%.

**Bezugszeichenliste**

| 1 | Herkömmliches Netzteil, Arbeitsschaltung |
| 10 | Erfindungsgemäßes Netzteil |
| 1' | Arbeitsschaltung des erfindungsgemäßen Netzteils |
| 2 | Passives PFC |
| 3 | Gleichrichter |
| 4 | Primärkondensator, primärer Elektrolytkondensator |
| 5 | Übertrager, Sperrwandler |
| 6 | Sekundärkondensator, sekundärer Elektrolytkondensator |
| 6', 6", 6''' | Sekundärkondensator des erfindungsgemäßen Netzteils |
| 7 | Ausgangsfilter, Tiefpass |
| 8 | Messschaltung |
| 80 | Analog- Digital- Wandler |
| 81 | Mikroprozessor |
| 82 | Datenspeicher |
| 83 | Ausgabemittel |
| 84 | Eingabemittel |
| I | Primärseite |
| II | Sekundärseite |
| C | Kapazität des Kondensators |
| R1', R1", R1''' | Ladewiderstand |
| R3', R3", R3''' | Messwiderstand |
| R2', R4',R2" | Spannungsteiler |
| R4",R2''', R4''' | Spannungsteiler |
| R | Gesamtwiderstand des Widerstandsnetzwerkes aus R2' - R4', R2" - R4" oder R2''' - R4''' |
| S1', S1", S1 ''' | Schalter zum Einkoppeln und zum Auskoppeln eines Bauteils |
| S2', S2", S2''' | Messschalter zum Einkoppeln und Auskoppeln des Messwiderstandes des Bauteils |
| T', T", T''' | Ladeschalter zum Einkoppeln und Auskoppeln des Ladewiderstandes des ersten Bauteils |
| UC' | Spannung am ersten Bauteil / Kondensator |
| IC' | Strom am ersten Bauteil / Kondensator |
| UAC | Eingangswechselspannung |
| UDC | Ausgangsgleichspannung |

**Patentansprüche**

1. Netzteil, umfassend eine Messschaltung (8), eine Arbeitsschaltung (1'), einen Kondensator als erstes Bauteil (6') und einen weiteren Kondensator als mindestens ein zweites Bauteil (6") desselben Typs, **dadurch gekennzeichnet, dass** die beiden Bauteile (6', 6") unabhängig voneinander in die Arbeitsschaltung (1') oder in die Messschaltung (8) einkoppelbar oder auskoppelbar sind.

2. Netzteil nach Anspruch 1, das zum Einkoppeln oder Auskoppeln des ersten Bauteils (6') und des mindestens einen zweiten Bauteils (6") in die Arbeitsschaltung (1') oder in die Messschaltung (8) zwei Schalter umfasst, die den beiden Bauteilen jeweils zugeordnet sind.

3. Netzteil nach einem der vorherigen Ansprüche, **dadurch gekennzeichnet, dass** im Betrieb des Netzteils entweder das erste Bauteil (6') oder das mindestens eine zweite Bauteil (6") in die Arbeitsschaltung (1') eingekoppelt ist, wobei das andere der Bauteile (6", 6') in einem Messbetrieb der Messschaltung (8) in die Messschaltung (8) eingekoppelt ist.

4. Netzteil nach einem der vorherigen Ansprüche, **dadurch gekennzeichnet, dass** die Messschaltung (8) einen Messwiderstand (R3', R3") zum Entladen des in die Messschaltung (8) eingekoppelten ersten oder zweiten Bauteils (6', 6") während des Messbetriebes umfasst.

5. Netzteil nach einem der vorherigen Ansprüche, **dadurch gekennzeichnet, dass** sie einen Ladewiderstand (R1') zum Aufladen des ersten oder zweiten Bauteils (6', 6") umfasst.

6. Netzteil nach einem der vorherigen Ansprüche, **dadurch gekennzeichnet, dass** dem Messwiderstand (R3', R3") jeweils ein Messschalter (S2', S2") und/oder dem Ladewiderstand (R1', R1") jeweils ein Ladeschalter (T', T") zugeordnet ist, mit dem die Widerstände (R1', R1", R3', R3") jeweils in die Messschaltung (8) einkoppelbar und auskoppelbar sind.

7. Netzteil nach einem der vorherigen Ansprüche, **dadurch gekennzeichnet, dass** die Messschaltung (8) einen Prozessor (81) umfasst, mit dem im Messbetrieb eine Eigenschaft des in die Messschaltung (8) eingekoppelten ersten oder zweiten Bauteils (6', 6") erfassbar ist.

8. Netzteil nach einem der vorherigen Ansprüche, **dadurch gekennzeichnet, dass** die Messschaltung (80) einen Analog- Digital- Wandler (80) umfasst, zum Wandeln des im Messbetrieb durch das in die Messschaltung (8) einkoppelte erste oder zweite Bauteil (6', 6") fließenden Stromes ($I_C$) und/oder der am ersten oder zweiten Bauteil (6', 6") anliegenden Spannung ($U_C$).

9. Netzteil nach einem der vorherigen Ansprüche, **dadurch gekennzeichnet, dass** die Messschaltung (8) ein Ausgabemittel (83), insbesondere ein Display, zur Ausgabe von Messwerten und/oder Ergebniswerten, insbesondere von Alterungswerten, umfasst.

10. Netzteil nach einem der vorherigen Ansprüche, **dadurch gekennzeichnet, dass** das erste und das mindestens eine zweite Bauteil (6', 6") baugleich sind.

11. Verfahren zum Messen von Messwerten, mit denen eine Eigenschaft eines Kondensators als erstes Bauteil (6') eines Netzteils nach einem der vorherigen Ansprüche während eines Betriebes des Netzteils erfassbar ist, mit den Schritten:

    - Einkoppeln eines weiteren Kondensators als mindestens ein zweites Bauteil (6") in eine Arbeitsschaltung (1') des Netzteils,
    - Auskoppeln des ersten Bauteils (6') aus der Arbeitsschaltung (1'),
    - Erfassung von Messwerten, insbesondere eines durch das erste Bauteil (6') fließenden Stromes ($I_C$) und/oder einer am ersten Bauteil (6') anliegenden Spannung (Uc), und
    - Berechnung der Eigenschaft des ersten Bauteils (6').

12. Verfahren nach Anspruch 11, **dadurch gekennzeichnet, dass** aus der Eigenschaft durch Vergleich mit einem Referenzwert auf den Alterungszustand des ersten Bauteils (6') geschlossen wird.

13. Verfahren nach Anspruch 11 oder 12, wobei entweder das erste Bauteil (6') oder das mindestens eine zweite Bauteil (6") in die Arbeitsschaltung (1') eingekoppelt und das andere Bauteil (6', 6") aus der Arbeitsschaltung (1') ausgekoppelt ist, während eine Eigenschaft des anderen Bauteils (6', 6") mit der Messschaltung (8) gemessen wird.

14. Verfahren nach Anspruch 13, **dadurch gekennzeichnet, dass** die Messung für das erste oder das mindestens eine zweite Bauteil (6', 6") abwechselnd, insbesondere zyklisch, erfolgt.

**Claims**

1. Power supply unit, comprising a measuring circuit (8), a working circuit (1'), a capacitor as a first component (6') and a further capacitor as at least one second component (6") of the same type, **characterized in that** the two components (6', 6") can be coupled independently of one another into the working circuit (1') or into the measuring circuit (8) or decoupled therefrom.

2. Power supply unit according to claim 1, which comprises two switches for coupling or decoupling the first component (6') and the at least one second component (6") into the working circuit (1') or into the measuring circuit (8), said switches being respectively assigned to the two components.

3. Power supply unit according to one of the previous claims, **characterized in that**, during operation of the power supply unit, either the first component (6') or the at least one second component (6") is coupled into the working circuit (1'), wherein the other of the components (6", 6') is coupled into the measuring circuit (8) in a measuring operation of the measuring circuit (8).

4. Power supply unit according to one of the previous claims, **characterized in that** the measuring circuit (8) comprises a measuring resistor (R3', R3") for discharging the first or second component (6', 6") coupled into the measuring circuit (8) during measurement operation.

5. Power supply unit according to one of the previous claims, **characterized in that** it comprises a charging resistor (R1') for charging the first or second component (6', 6").

6. Power supply unit according to one of the preceding claims, **characterized in that** the measuring resistor (R3', R3") is assigned in each case a measuring switch (S2', S2") and/or the charging resistor (R1', R1") is assigned in each case a charging switch (T', T"), by means of which the resistors (R1', R1", R3', R3") can be coupled in each case into the measuring circuit (8) and decoupled therefrom.

7. Power supply unit according to one of the previous claims, **characterized in that** the measuring circuit (8) comprises a processor (81) with which a characteristic of the first or second component (6', 6") coupled into the measuring circuit (8) can be detected in the measuring operation.

8. Power supply unit according to one of the preceding claims, **characterized in that** the measuring circuit (80) comprises an analog-to-digital converter (80) for converting the current ($I_C$) flowing in the measuring operation through the first or second component (6', 6") coupled into the measuring circuit (8) and/or the voltage ($U_C$) applied to the first or second component (6', 6").

9. Power supply unit according to one of the previous claims, **characterized in that** the measuring circuit (8) comprises an output means (83), in particular a display, for outputting measured values and/or result values, in particular ageing values.

10. Power supply unit according to one of the previous claims, **characterized in that** the first and the at least one second component (6', 6") are of identical construction.

11. Method for measuring measured values, with which a characteristic of a capacitor as a first component (6') of a power supply unit according to one of the previous claims can be detected during operation of the power supply, comprising the steps of:

   - coupling a further capacitor as at least one second component (6") into a working circuit (1') of the power supply unit,
   - decoupling the first component (6') from the working circuit (1'),
   - detection of measured values, in particular a current ($I_C$) flowing through the first component (6') and/or a voltage (Uc) applied to the first component (6'), and
   - calculation of the characteristic of the first component (6').

12. Method according to claim 11, **characterized in that** the ageing state of the first component (6') is inferred from the characteristic by comparison with a reference value.

13. Method according to claim 11 or 12, wherein either the first component (6') or the at least one second component (6") is coupled into the working circuit (1') and the other component (6', 6") is decoupled from the working circuit (1') while a characteristic of the other component (6', 6") is measured with the measuring circuit (8).

14. Method according to claim 13, **characterized in that** the measurement for the first or at least one second component (6', 6") takes place alternately, in particular cyclically.

**Revendications**

1. Bloc d'alimentation électrique comprenant un circuit de mesure (8), un circuit de travail (1'), un condensateur en tant que premier composant (6') et un autre condensateur en tant qu'au moins un deuxième composant (6") du même type, **caractérisé en ce que** les deux composants (6', 6") peuvent être couplés ou découplés indépendamment l'un de l'autre dans le circuit de travail (1') ou le circuit de mesure (8).

2. Bloc d'alimentation électrique selon la revendication 1, qui comprend deux commutateurs qui sont respectivement associés aux deux composants pour coupler ou découpler le premier composant (6') et ledit au moins un deuxième composant (6") dans le circuit de travail (1') ou dans le circuit de mesure (8).

3. Bloc d'alimentation électrique selon l'une des revendications précédentes, **caractérisé en ce que**, pendant le fonctionnement du bloc d'alimentation électrique, soit le premier composant (6'), soit ledit au moins un deuxième composant (6") est couplé dans le circuit de travail (1'), l'autre des composants (6", 6') étant couplé dans le circuit de mesure (8) dans un mode de mesure du circuit de mesure (8).

4. Bloc d'alimentation électrique selon l'une des revendications précédentes, **caractérisé en ce que** le circuit de mesure (8) comprend une résistance de mesure (R3', R3") pour décharger le premier ou le deuxième composant (6', 6") couplé dans le circuit de mesure (8) pendant le mode de mesure.

5. Bloc d'alimentation électrique selon l'une des revendications précédentes, **caractérisé en ce qu'**il comprend une résistance de charge (R1') pour charger le premier ou le deuxième composant (6', 6").

6. Bloc d'alimentation électrique selon l'une des revendications précédentes, **caractérisé en ce qu'**à la résistance de mesure (R3', R3") est associé respectivement un commutateur de mesure (S2', S2") et/ou à la résistance de charge (R1', R1") respectivement un commutateur de charge (T', T") avec lequel les résistances (R1', R1", R3', R3") peuvent respectivement être coupées et découplées dans le circuit de mesure (8).

7. Bloc d'alimentation électrique selon l'une des revendications précédentes, **caractérisé en ce que** le circuit de mesure (8) comprend un processeur (81) avec lequel une propriété du premier ou du deuxième composant (6', 6") couplé dans le circuit de mesure (8) peut être détectée en mode de mesure.

8. Bloc d'alimentation électrique selon l'une des revendications précédentes, **caractérisé en ce que** le circuit de mesure (80) comprend un convertisseur analogique-numérique (80) pour convertir le courant (Ic) circulant à travers le premier ou le deuxième composant (6', 6") couplé dans le circuit de mesure (8) et/ou la tension (Uc) présente au premier ou au deuxième composant (6', 6") en mode de mesure.

9. Bloc d'alimentation électrique selon l'une des revendications précédentes, **caractérisé en ce que** le circuit de mesure (8) comprend un moyen de sortie (83), en particulier un affichage, pour délivrer des valeurs de mesure et/ou des valeurs de résultat, en particulier des valeurs de vieillissement.

10. Bloc d'alimentation électrique selon l'une des revendications précédentes, **caractérisé en ce que** le premier et ledit au moins un deuxième composant (6', 6") sont de construction identique.

11. Procédé pour mesurer des valeurs de mesure avec lesquelles une propriété d'un condensateur en guise de premier composant (6') d'un bloc d'alimentation électrique selon l'une des revendications précédentes peut être détectée pendant un fonctionnement du bloc d'alimentation électrique, comprenant les étapes suivantes :

    - couplage d'un autre condensateur en guise d'au moins un deuxième composant (6") dans un circuit de travail (1') du bloc d'alimentation électrique,
    - découplage du premier composant (6') du circuit de travail (1'),
    - détection de valeurs de mesure, en particulier d'un courant (Ic) circulant à travers le premier composant (6') et/ou d'une tension (Uc) présente au premier composant (6') et
    - calcul de la propriété du premier composant (6').

12. Procédé selon la revendication 11, **caractérisé en ce que** l'état de vieillissement du premier composant (6') est déduit de la propriété par comparaison avec une valeur de référence.

13. Procédé selon la revendication 11 ou 12, dans lequel soit le premier composant (6'), soit ledit au moins un deuxième composant (6") est couplé dans le circuit de travail (1') et l'autre composant (6', 6") est découplé du circuit de travail (1') pendant qu'une propriété de l'autre composant (6', 6") est mesurée avec le circuit de mesure (8).

14. Procédé selon la revendication 13, **caractérisé en ce que** la mesure pour le premier ou ledit au moins un deuxième composant (6', 6") a lieu en alternance, en particulier de manière cyclique.

**Fig. 1   (Stand der Technik)**

EP 2 936 174 B1

Fig. 2

Fig. 3

Fig. 4

Fig. 5

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005058719 A1
- US 2006038692 A